# EUROPÄISCHE PATENTSCHRIFT

(11) **EP 3 917 796 B1**
(45) Veröffentlichungstag und Bekanntmachung des Hinweises auf die Patenterteilung: **23.11.2022**
(21) Anmeldenummer: 20702793.9
(22) Anmeldetag: 30.01.2020
(51) Int. Cl.: B60K 37/06, G06F 3/01, H01H 3/12, G06F 3/041, H03K 17/965

(54) **BEDIENVORRICHTUNG FÜR EIN FAHRZEUG**
OPERATING DEVICE FOR A VEHICLE
DISPOSITIF DE COMMANDE D'UN VÉHICULE

(30) Priorität: 31.01.2019 DE 102019102461
(43) Veröffentlichungstag der Anmeldung: 08.12.2021
(73) Patentinhaber: Behr-Hella Thermocontrol GmbH, 59557 Lippstadt (DE)
(72) Erfinder: KIRSCH, Stefan, 59557 Lippstadt (DE); KEMPPINEN, Pasi, 33800 Tampere (FI)
(74) Vertreter: dompatent von Kreisler Selting Werner - Partnerschaft von Patent- und Rechtsanwälten mbB
(86) Internationale Anmeldenummer: PCT/EP2020/052347
(87) Internationale Veröffentlichungsnummer: WO 2020/157231

(56) Entgegenhaltungen:
- WO-A1-2016/012277
- WO-A1-2018/046302
- DE-A1-102015 008 573

## Beschreibung

Die Erfindung betrifft eine Bedienvorrichtung für ein Fahrzeug, beispielsweise für eine Fahrzeugkomponente wie eine Klimaanlage, ein Infotainment-System oder ein Navigationssystem. Ganz allgemein betrifft die Erfindung ein Mensch-Maschine-Interface für ein Fahrzeug.

Der Einsatz von Displays im Fahrzeug, die als Touchscreen ausgeführt der Eingabe von Bedienbefehlen oder der Einstellung von Parametern dienen, erfreut sich zunehmender Beliebtheit. Um dem Benutzer zu signalisieren, dass er den Touchscreen betätigt hat, haben sich Systeme mit haptischem Feedback bewährt. Dabei wird das Display bzw. Teile des Displays wie beispielsweise die Abdeckscheibe (ggf. mit Touchpanel) impulsartig mechanisch angeregt. Der für diese Zwecke erforderliche Aktuator befindet sich im Regelfall unterhalb des mechanisch angeregten Displays bzw. unterhalb des mechanisch angeregten Teils des Displays. Wird das Display bzw. das betreffende Teil des Displays zwecks lateraler Verschiebung impulsartig angeregt, so erfährt das Display bzw. das entsprechende Teil des Displays eine leichte Kippbewegung, wenn die Wirkrichtung, in der der Aktuator auf das Display bzw. das entsprechende Teil des Displays einwirkt, nicht in derjenigen Ebene verläuft, die durch die Lateralverschiebung und den Massenschwerpunkt des Displays bzw. des betreffenden Teils des Displays definiert ist. Das Display erfährt also damit ein hinsichtlich einer potentiellen Geräuschentwicklung störendes Drehmoment, das möglicherweise durch eine recht aufwändige Lagerung aufgefangen werden kann. Dies ist allerdings mit zusätzlichen Kosten verbunden.

Aus DE-A-10 2015 008 573 ist eine Bedieneinheit für ein Fahrzeug nach dem Oberbegriff des Anspruchs 1 bekannt.

Aus US-A-2019/0191582 ist eine Bedienvorrichtung mit haptischem Feedback bekannt, bei dem ein Linear-Aktuator verwendet wird, der als flaches Makrofaserkomposite-Laminat mit integrierten Piezoelementen ausgebildet ist.

Aufgabe der Erfindung ist es, eine Bedieneinheit für ein Fahrzeug mit haptischem Feedback zu schaffen, bei dem das für die taktile Rückmeldung mechanisch angeregte Teil der Bedieneinheit im Wesentlichen eine translatorische Bewegung, insbesondere eine translatorische Lateral-Bewegung vollführt. Zur Lösung dieser Aufgabe wird mit der Erfindung eine Bedieneinheit für ein

Fahrzeug gemäß Anspruch 1 vorgeschlagen, die versehen ist mit
- einem Gehäuse mit einer Vorderseite,
- einem Bedienelement an der Vorderseite des Gehäuses,
- wobei das Bedienelement ein Display mit einer Anzeigefläche und einer Abdeckscheibe aufweist, die eine Bedienoberfläche des Bedienelements definiert und zumindest einen seitlich über das Display überstehenden Überstandsbereich aufweist,
- wobei die Abdeckscheibe an und/oder in dem Gehäuse elastisch lateral verschiebbar direkt oder indirekt gelagert ist,
- einer Sensorik zur Ermittlung einer durch Berührung der Bedienoberfläche mit einer vorgebbaren Mindestandrückkraft erfolgenden manuellen Betätigung des Bedienelements,
- einem unterhalb der Abdeckscheibe angeordneten Aktuator mit einem Antrieb und einem von dem Antrieb angetriebenen Stellelement,
- wobei der Antrieb des Aktuators direkt oder indirekt starr mit dem Gehäuse gekoppelt ist und sich an diesem abstützt,
- einem elastisch ausgebildeten Betätigungsarm, der von dem Überstandbereich der Abdeckscheibe absteht und auf den das Stellelement des Aktuators an einem Einwirkungspunkt des Betätigungsarms mechanisch einwirkt, womit das Stellelement des Aktuators und der Betätigungsarm an dessen Einwirkungspunkt mechanisch gekoppelt sind,
- wobei der Betätigungsarm einen sich zwischen der Abdeckscheibe und dem Einwirkungspunkt erstreckenden Verschiebeabschnitt zur Lateralverschiebung der Abdeckscheibe aufweist und
- wobei der Betätigungsarm ausgehend von seinem Verschiebeabschnitt über den Einwirkungspunkt hinaus verlängert ist und einen Verlängerungsabschnitt aufweist, innerhalb dessen der Betätigungsarm elastisch und mechanisch fixiert ist, und
- einer Auswerte- und Ansteuereinheit, die von der Sensorik Messsignale empfängt und bei Erkennung einer validen Betätigung des Bedienelements an den Antrieb des Aktuators ein Ansteuersignal zur pulsartigen mechanischen z.B. Einmalpulsanregung, Anregung des Betätigungsarms durch das Stellelement des Aktuators ausgibt.

Die erfindungsgemäße Bedieneinheit ist mit einem Gehäuse versehen, an dessen Vorderseite ein Bedienelement angeordnet ist. Das Bedienelement ist als Display ausgeführt und weist eine Anzeigefläche sowie eine Abdeckscheibe auf, die die Bedienoberfläche des Bedienelements bildet und einen seitlich über das Display überstehenden Überstandsbereich aufweist. Die Abdeckscheibe ist elastisch lateral verschiebbar gelagert. Mithilfe einer Sensorik wird erkannt, ob der Benutzer bei Berührung der Bedienoberfläche mit einer vorgebbaren Mindestandrückkraft gegen die Andrückfläche gedrückt hat. Ist dies der Fall, was eine mit der Sensorik verbundene Auswerte- und Ansteuereinheit ermittelt, so wird ein Aktuator angesteuert, der die Abdeckscheibe impulsartig mechanisch zur Seite verschiebt. Die mechanische Kopplung zwischen Aktuator und Abdeckscheibe erfolgt in deren Überstandsbereich, innerhalb dessen ein elastischer Betätigungsarm mit der Abdeckscheibe verbunden ist. Der Aktuator wirkt an einem Einwirkungspunkt auf den Betätigungsarm ein, der zwischen dem Einwirkungspunkt und seiner Verbindung mit der Abdeckscheibe einen Verschiebeabschnitt zur seitlichen Verschiebung der Abdeckplatte aufweist. Aktuator und Betätigungsarm sind also zwei Bauteile, die an dem Einwirkungspunkt des Betätigungsarms miteinander mechanisch gekoppelt, insbesondere verbunden sind.

Erfindungsgemäß ist der Betätigungsarm über den Einwirkungspunkt hinaus verlängert und weist in diesem Bereich einen Verlängerungsabschnitt auf, der im Gehäuse oder außerhalb des Gehäuses fixiert ist.

Das erfindungsgemäße Konzept zum Ausgleich eines auf die Abdeckscheibe wirkenden Drehmoments, welches dadurch entsteht, dass der Aktuator um den Abstand zwischen Einwirkungspunkt des Betätigungsarms und dessen Verbindung zur Abdeckscheibe von dieser beabstandet ist, wird nun erfindungsgemäß dadurch kompensiert, dass der Betätigungsarm, bezogen auf den Einwirkungspunkt, zu der der Abdeckscheibe gegenüberliegenden Seite verlängert ist und innerhalb dieses Verlängerungsabschnitts im Gehäuse oder außerhalb des Gehäuses fixiert ist. Dadurch nämlich wirkt im Verlängerungsabschnitt des Betätigungsarms ein Drehmoment, das dem im Verschiebeabschnitt des Betätigungsarms wirkenden Drehmoment entgegenwirkt. Somit kommt es im Wesentlichen zu einem Drehmomentenausgleich, was sich insoweit vorteilhaft auf die Abdeckscheibe auswirkt, als diese nun im Wesentlichen translatorisch, nämlich lateral verschoben wird.

Der erfindungsgemäß elastisch ausgebildete Betätigungsarm kann gemäß einem Ausführungsbeispiel der Erfindung als (insbesondere Flach-) Materialstreifen aus vorzugsweise Metall und insbesondere Eisen oder Stahl, insbesondere Federstahl, ausgeführt sein. Der Betätigungsarm kann auch aus Kunststoff geformt sein, wobei die Formgebung durch z.B. unterschiedlichen Materialdicken dem Materialstreifen die gewünschte Elastizität verleiht.

Zusätzliche Elastizität kann dem Betätigungsarm innerhalb seines Verlängerungsabschnitts dadurch verliehen werden, das der Betätigungsarm gemäß einer insoweit zweckmäßigen Weiterführung der Erfindung innerhalb seines Verlängerungsabschnitts einen Bogenabschnitt von im Wesentlichen 180 Grad aufweist, innerhalb des Verlängerungsabschnitts also im wesentlichen U-förmig geformt ist, wobei das nach der 180 Grad Krümmung zurückgeführte Ende des Verlängerungsabschnitts mechanisch an und/oder in dem Gehäuse fixiert ist.

Bei einer weiteren Variante der Erfindung kann vorgesehen sein, dass der Verlängerungsabschnitt an seinem Ende unter Zwischenschaltung eines elastischen, dehnbaren Materials (z.B. Elastomermaterial wie Gummi oder Silikon) im oder am Gehäuse befestigt ist. Bei dieser Ausführung des Betätigungsarms kann dieser beispielsweise im Verlängerungsabschnitt um eine parallel zur Abdeckscheibe verlaufende, orthogonal zur Wirkachse des Aktuators gerichtete Achse abgewinkelt sein, wobei das Ende des abgewinkelten Endabschnitts des Verlängerungsabschnitts unter Zwischenschaltung eines elastischen, insbesondere elastisch scherenden Verbindungselements am oder im Gehäuse fixiert ist.

In weiterer zweckmäßiger Ausführung der Erfindung kann vorgesehen sein, dass der Verlängerungsabschnitt zwei Teilabschnitte aufweist, die elastisch miteinander verbunden sind, wobei sich der erste Teilabschnitt ausgehend von dem Einwirkungspunkt des Betätigungsarms erstreckt und der zweite Teilabschnitt an dem dem Einwirkungspunkt des Betätigungsarms gegenüberliegenden Ende des ersten Teilabschnitts mit diesem verbunden ist.

Diese beiden Teilabschnitte können gemäß einer ersten Variante einteilig durch einen Bogenabschnitt verbunden sein, der um eine gedachte Achse gekrümmt verläuft, die parallel zur Abdeckscheibe und quer zur Wirkachse des Aktuators verläuft. Durch den Bogenabschnitt wird dem Verlängerungsabschnitt des Betätigungsarms zusätzlich eine Elastizität verliehen, die für die Kompensation des zwischen Einwirkungspunkt und Abdeckscheibe wirkenden Drehmoments sorgt. Die beiden Teilabschnitte können aber auch unter Zwischenschaltung eines elastischen Elements (Sandwich) miteinander verbunden sein. Hier sorgt dann das elastische Material des Elements, das insbesondere dehnbar und/oder kompressibel ist, für die zusätzliche Flexibilität des Betätigungsarms in dessen Verlängerungsabschnitt.

Als Aktuator eignet sich insbesondere ein elektromechanischer oder elektromagnetischer Antrieb. Als Antrieb kommt aber gemäß einer Weiterführung der Erfindung insbesondere auch ein Piezoaktuator mit oder ohne Verstärkungsgetriebe in Frage, wobei der Piezoaktuator bei nicht gegebenem Verstärkungsgetriebe gleichermaßen den Antrieb und das Stellelement des Aktuators bildet, während bei Vorhandensein eines Verstärkungsgetriebes für den Piezoaktuator der Piezoaktuator den Antrieb repräsentiert und das Verstärkungsgetriebe das Stellelement des Aktuators ist.

Die erfindungsgemäße Bedienvorrichtung lässt sich zweckmäßigerweise mit einer vereinfachten Konstruktion für die messtechnische Detektion der Mindestandrückkraft kombinieren. Dies soll nachfolgend erläutert werden.

Insoweit von Vorteil ist, eine Bedienvorrichtung für ein Fahrzeug anzugeben, deren Konstruktion zur Messung der Auslösekraft bei der manuellen Betätigung des Displays vereinfacht ist.

Gemäß einer Ausgestaltung der Erfindung gelingt dies bei einer Bedienvorrichtung, die versehen ist mit
- einem Gehäuse mit einer Vorderseite, die eine von einem Öffnungsrand begrenzte Aufnahmeöffnung aufweist, und mit einer Rückwand,
- einem in der Aufnahmeöffnung mit Abstand zu deren Öffnungsrand angeordneten, eine Bedienoberfläche aufweisenden Bedienelement, das eine Vorderseite mit der Bedienoberfläche versehene Vorderseite, eine Rückseite und einen Begrenzungsrandbereich aufweist,
- einem Halteelement, das eine Bodenwand und von dieser aufragende Stützteile aufweist, die unterhalb des Begrenzungsrandbereichs des Bedienelements enden und mit diesem in dessen Begrenzungsrandbereich mechanisch gekoppelt sind,
- wobei die Bodenwand des Halteelements einen von den Stützteilen beabstandeten Mittenbereich aufweist, innerhalb dessen sich die Bodenwand des Halteelements an der Rückwand des Gehäuses abstützt,
- mehreren eine manuelle Betätigung des Bedienelements erfassenden Betätigungssensoren, die innerhalb des den Mittenbereich der Bodenwand des Halteelements umgebenden, einen Abstand zur Rückwand des Gehäuses aufweisenden Umgebungsbereichs zwischen der Bodenwand des Halteelements und der Rückwand des Gehäuses angeordnet sind, und
- einer Auswerteeinheit, die Signale von den Betätigungssensoren empfängt und diese zwecks Erkennung einer manuellen Betätigung des Bedienelements mit einer vorgebbaren Mindestandrückkraft auswertet.

Mit dieser Variante der Erfindung wird sinngemäß vorgeschlagen, das Halteelement, das das Bedienelement stützt, für die Übertragung der Andrücckraft an entsprechende Betätigungssensoren zu nutzen, die sensieren, mit welcher Andrückkraft die Bedienoberfläche des Bedienelements betätigt wird.

Das Halteelement ist im Wesentlichen als mulden- bzw. wannenförmiges Element ausgebildet, das eine Bodenwand aufweist, von der an vorzugsweise sämtlichen Randabschnitten Stützteile aufragen. Insbesondere weist die Bodenwand eine umlaufende aufragende Umfangswand auf, die zweckmäßigerweise in einen ebenfalls umlaufenden Flansch übergeht. Die Stützteile sind dann bei dieser Ausgestaltung der Erfindung als diejenigen Seitenwandabschnitte ausgebildet, die längs jedes Randabschnitts der Bodenwand von dieser aufragen. Es ist aber auch denkbar, dass von der Bodenwand an vorzugsweise sämtlichen Randabschnitten einzelne, voneinander getrennte und damit beabstandete Stützteile aufragen.

Die Stützteile sind in einem Begrenzungsrandbereich des Bedienelements mit diesem gekoppelt. Das Bedienelement selbst weist eine die Bedienoberfläche bildende Vorderseite, eine Rückseite und den zuvor genannten umlaufenden Begrenzungsrandbereich auf.

Das Halteelement selbst befindet sich in dem Gehäuse der Bedienvorrichtung, das eine Vorderseite aufweist, die eine von einem Öffnungsrand begrenzte Aufnahmeöffnung aufweist, innerhalb derer das Bedienelement angeordnet ist. Das Gehäuse weist ferner eine Rückwand auf. Schließlich weist das Gehäuse auch Seitenwände auf.

Eine Besonderheit der erfindungsgemäßen Bedienvorrichtung ist darin zu sehen, dass das Halteelement in einem Mittenbereich seiner Bodenwand starr mit der Rückwand des Gehäuses verbunden ist. Die Rückwand stützt also in diesem Mittenbereich der Bodenwand das Halteelement. Außerhalb des Mittenbereichs, d.h. im Umgebungsbereich des Mittenbereichs der Bodenwand, ist das Halteelement zur Rückwand des Gehäuses beabstandet; zwischen Halteelement und Rückwand bildet sich ein Ringspalt.

Wird nun die Bedienoberfläche des Bedienelements manuell betätigt, so erfährt das Halteelement und insbesondere dessen Bodenwand ein Biegemoment. Denn die Kraft, mit der manuell gegen die Bedienoberfläche des Bedienelements gedrückt wird, wird über den Begrenzungsrandbereich des Bedienelements und die mit diesem Begrenzungsrandbereich mechanisch gekoppelten Stützteile in die Bodenwand übertragen. Da die Bodenwand zentral gelagert ist und ansonsten einen Spalt zur Rückwand des Gehäuses aufweist, kann sich die Bodenwand nun wie ein einseitig eingespannter Biegebalken verformen bzw. dementsprechende Biegemomente aufnehmen. Diese werden an Betätigungssensoren übertragen, die sich zwischen dem Umgebungsbereich um den Mittenbereich der Bodenwand herum und der Rückwand des Gehäuses befinden. Die Betätigungssensoren können als Weg- und/oder als Kraft- und/oder als Drucksensoren ausgeführt sein. Insbesondere eignen sich MEMS-Bauteile (mikroelektronische mechanische Sensoren). Die Messsignale der Betätigungssensoren werden an eine Auswerteeinheit übertragen, die unter anderem einen Mikroprozessor mit entsprechender Hardware-Umgebung aufweist. In der Auswerteeinheit werden die Messsignale der Betätigungssensoren ausgewertet, und zwar zwecks Erkennung einer validen manuellen Betätigung, d.h. einer Betätigung des Bedienelements mit einer vorgebbaren Mindestandrückkraft. Somit können also Fehlbedienungen des Bedienelements ausgeschlossen werden.

Die Bedienvorrichtung gemäß dieser Weiterbildung der Erfindung zeichnet sich durch eine kompakte Bauweise aus. Die schubsteife Verbindung des Halteelements mit der Rückwand des Gehäuses erlaubt es, zwischen dem Halteelement und dem Bedienelement einen Aktuator für ein gegebenenfalls gewünschtes haptisches Feedback der Bedienvorrichtung vorzusehen. In diesem Fall würde sich der Aktuator einerseits an dem Halteelement abstützen, um das Bedienelement impulsartig mechanisch anzuregen, und zwar beispielsweise zwecks lateraler impulsartiger Bewegung des Bedienelements, was manuell taktil erfassbar ist und somit eine valide Betätigung des Bedienelements taktil rückmeldet.

In weiterer vorteilhafter Ausgestaltung ist vorgesehen, dass die Auswerteeinheit ferner die Signale der Betätigungssensoren zwecks Erkennung derjenigen Position auf der Bedienoberfläche des Bedienelements auswertet, an der die manuelle Betätigung des Bedienelements erfolgt.

Alternativ oder auch zusätzlich kann das Bedienelement versehen sein mit einer Berührungssensorik zur Erkennung derjenigen Position auf der Bedienoberfläche des Bedienelements, an der die manuelle Betätigung des Bedienelements erfolgt. Die Berührungssensorik kann kapazitiv, resistiv oder optisch arbeiten. Im Falle des Einsatzes von MEMS kann das Biegemoment, dem die Bodenwand des Halteelements bei einer manuellen Betätigung der Bedienoberfläche des Bedienelements ausgesetzt ist, auf Biegebalken, Biegemembranen o.dgl. übertragen werden, wobei die mechanische Verbiegung dieser mikromechanischen Elemente der MEMS durch Transistor- oder Widerstandsmessdrücken bzw. anderen mikromechanischen, mikroelektrischen Bauelementen erfasst wird.

In weiterer zweckmäßiger Ausgestaltung können die Stützteile und der Begrenzungsrandbereich des Bedienelements starr miteinander verbunden sein.

Wie bereits oben erwähnt, ist die erfindungsgemäße Bedienvorrichtung auch mit einer Haptik-Feedback-Funktionalität ausgestattet. Dabei verfährt man im Allgemeinen dergestalt, dass die Bedienoberfläche mechanisch angeregt wird, wenn eine valide Betätigung detektiert worden ist. Dazu müsste das Bedienelement samt Halteelement elastisch angebunden sein. Bei dem im Rahmen dieser Erfindung vorgestellten Konzept der schubsteifen Verbindung des Halteelements des Bedienelements mit der Rückwand des Gehäuses verbleibt dann also zur mechanischen Anregung für die Haptik-Feedback-Funktionalität das Bedienelement, das zu diesem Zweck mit den Stützteilen des Halteelements elastisch und damit rückstellfähig verbunden sein muss. Insoweit schlägt also eine Variante der Erfindung vor, dass die Stützteile und der Begrenzungsrandbereich des Bedienelements mittels eines zwischen diesen angeordneten rückstellfähigen Verbindungselements miteinander mechanisch gekoppelt sind.

Besonders vorteilhaft ist es, wenn das Verbindungselement nach einer senkrecht zur Bedienoberfläche des Bedienelements erfolgenden Komprimierung rückstellfähig und bei einer orthogonal hierzu erfolgenden Verschiebung des Bedienelements rückstellfähig scherbar ist. Als Material für das Verbindungselement eignet sich elastomeres Material wie beispielsweise Gummi oder Silikon. Das Verbindungselement ist zweckmäßigerweise als Streifenmaterial ausgebildet, das vorzugsweise längs des gesamten Begrenzungsrandbereichs verläuft und diesen an die Stützteile des Halteelements mechanisch ankoppelt. Durch die geometrische Form des Streifenmaterials lässt sich dessen Elastizität senkrecht zur Bedienoberfläche und quer dazu in gewissen Grenzen beeinflussen. Es ist auch möglich, Verbundmaterial einzusetzen, d.h. elastomeres Material und in dieses eingebettete starre Körper, die die Komprimierbarkeit senkrecht zur Bedienoberfläche stark reduzieren bzw. gänzlich unterbinden, nichtsdestotrotz aber die quer dazu gerichtete Scherbarkeit des Verbindungselements weiterhin gewährleiten.

Mit dem zuvor beschriebenen Konzept der elastischen Anbindung des Bedienelements an das Halteelement ist es nun möglich, zwischen dem Halteelement und dem Bedienelement einen Aktuator für das haptische Feedback anzuordnen, der sich am Halteelement (und damit über dieses am Gehäuse) abstützt und mit seinem Stellglied das Bedienelement mechanisch anregt. Als Aktuator eignet sich beispielsweise ein elektromechanischer Aktuator wie beispielsweise ein Zuganker, oder aber auch ein Piezoaktuator (mit oder ohne Verstärkungsgetriebe).

In weiterer vorteilhafter Ausgestaltung kann vorgesehen sein, dass das Bedienelement ein Display mit einer Information anzeigenden Vorderseite aufweist, die die Bedienoberfläche des Bedienelements bildet. Hierbei kann das Display eine die Bedienoberfläche definierende Abdeckscheibe mit einer hinter dieser angeordneten Anzeigeeinheit zur optischen Anzeige von Informationen aufweisen. Bei einer derartigen Ausgestaltung des Bedienelements mit Display steht die Abdeckscheibe zweckmäßigerweise allseitig über die Anzeigeeinheit über, wobei dieser Überstandsbereich den Begrenzungsrandbereich des Bedienelements bildet.

Die heutzutage bei Bedienvorrichtungen überwiegend eingesetzten Displays arbeiten mit LCD-Technologie. Zwecks besserer Sichtbarmachung der angezeigten Information sind derartige Displays mit Hinterleuchtungseinheiten ausgestattet. Das Halteelement, das bei der erfindungsgemäßen Bedienvorrichtung das Bedienelement stützt, kann nun zweckmäßigerweise zur Aufnahme einer derartigen Hinterleuchtungseinheit verwendet werden. Alternativ werden aber auch Displays eingesetzt, bei denen die einzelnen Pixel dann, wenn sie zur Anzeige von Information benötigt werden, sozusagen selbsttätig leuchten. Das Display ist also anders als bei der LCD-Technologie nicht als eine Art Shutter ausgebildet, sondern ist mit aktiv für die Aufleuchtung ansteuerbaren einzelnen Pixel versehen. Ein Beispiel für ein derartiges Display ist beispielsweise ein OLED-Display. Bei den zwecks Aufleuchtung einzelner Pixel aktiv ansteuerbaren Displays bedarf es an sich einer Hinterleuchtungseinheit nicht mehr. Das Halteelement erfüllt bei derartigen Displays dann die Funktion eines mechanischen Schutzes der Rückseite des Displays, die das Halteelement im Übrigen auch dann ausübt, wenn das Display eine vom Halteelement aufgenommene Hinterleuchtungseinheit aufweist. In beiden Fällen deckt das Halteelement die Rückseite des Displays mehr oder weniger ab.

Das zuvor vorgestellte Konzept, das Halteelement für die Übertragung der bei einer manuellen Betätigung auf das Bedienelement wirkenden Momente zu nutzen, ist in all diesen Fällen dasselbe.

Die Erfindung wird nachfolgend anhand von Ausführungsbeispielen und unter Bezugnahme auf die Zeichnung näher erläutert. Im Einzelnen zeigen dabei:
- Fig. 1: eine Schnittansicht durch den Aufbau einer Bedienvorrichtung, bei der sich die Erfindung realisieren lässt,
- Fig. 2: eine Draufsicht auf die Bedienvorrichtung,
- Fig. 3: die Situation, in der mit einem Finger einer Hand Druck auf die Bedienoberfläche des Bedienelements der Bedienvorrichtung ausgeübt wird, und
- Fig. 4: die Situation, in der infolge einer validen Betätigung der Bedienoberfläche des Bedienelements dieses mechanisch impulsartig lateral angeregt wird.
- Fig. 5: ein erstes Ausführungsbeispiel der erfindungsgemäß ausgestalteten Bedienvorrichtung nach den Figuren 1 bis 4, wobei die Bedienvorrichtung im noch nicht lateral angeregten Zustand gezeigt ist,
- Fig. 6: die Bedienvorrichtung gemäß Fig. 5 bei lateraler Anregung der Abdeckscheibe zum Erzeugen eines haptischen Feedbacks,
- Fig. 7: ein zweites Ausführungsbeispiel der erfindungsgemäß ausgestalteten Bedienvorrichtung nach den Fign. 1 bis 4, wobei die Bedienvorrichtung im noch nicht lateral angeregten Zustand angezeigt ist,
- Fig. 8: die Bedienvorrichtung gemäß Fig. 7 bei lateraler Anregung der Abdeckscheibe zum Erzeugen eines haptischen Feedbacks,
- Fig. 9: ein drittes Ausführungsbeispiel der erfindungsgemäß ausgestalteten Bedienvorrichtung nach den Fign. 1 bis 4, wobei die Bedienvorrichtung im noch nicht lateral angeregten Zustand angezeigt ist und
- Fig. 10: die Bedienvorrichtung gemäß Fig. 9 bei lateraler Anregung der Abdeckscheibe zum Erzeugen eines haptischen Feedbacks.

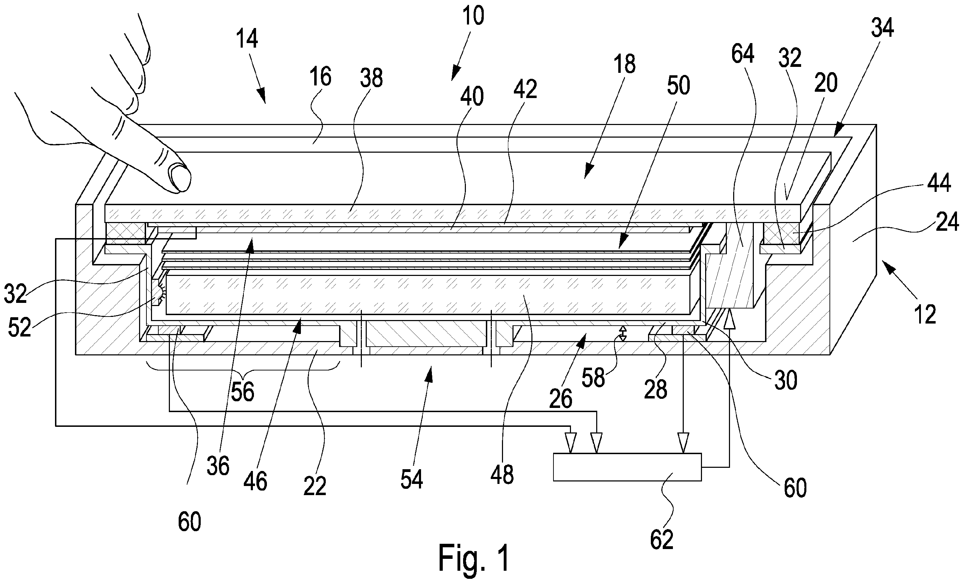

Fig. 1 zeigt schematisch den grundsätzlichen Aufbau einer Bedienvorrichtung 10 gemäß einem Ausführungsbeispiel der Erfindung. Die Bedienvorrichtung 10 weist ein Gehäuse 12 auf, das an seiner Vorderseite 14 eine Aufnahmeöffnung 16 aufweist, innerhalb derer ein Bedienelement 18 mit einer Bedienoberfläche 20 angeordnet ist. Das Gehäuse weist ferner eine Rückwand 22 auf, die über Seitenwände 24 mit der Vorderseite 14 des Gehäuses 12 verbunden ist.

Innerhalb des Gehäuses 12 befindet sich ein in diesem Ausführungsbeispiel wannenförmiges Halteelement 26, das eine Bodenwand 28 aufweist, von der allseitig der Bodenwand 28 aufragende Stützteile 30 hochstehen, die in einen nach außen weisenden Montageflansch 32 übergehen. Der Montageflansch 32 ist mit dem umlaufenden Begrenzungsrandbereich 34 des Bedienelements 18 mechanisch gekoppelt.

In diesem Ausführungsbeispiel ist das Bedienelement 18 als Display 36 ausgebildet. Das Display 36 weist eine Abdeckscheibe 38 auf, deren Vorderseite die Bedienoberfläche 20 des Bedienelements 18 bildet. Hinter der Abdeckscheibe 38 befindet sich die Anzeigeeinheit 40 (beispielsweise in LCD-Technologie realisiert). Ferner kann das Display 36 auch noch eine Berührungssensorik in Form eines Touch-Panel 42 aufweisen. Derartige Displays sind im Stand der Technik grundsätzlich bekannt und sollen hier nicht weiter beschrieben werden.

Im Begrenzungsrandbereich 34 der Abdeckscheibe 38 ist diese rückstellfähig mit dem Montageflansch 32 verbunden. Dies erfolgt durch ein Verbindungselement 44, das in diesem Ausführungsbeispiel als längs des Montageflansches 32 verlaufendes elastomeres Band ausgeführt ist. Das Verbindungselement ist beispielsweise mit dem Montageflansch 32 und mit der Abdeckscheibe 38 schubsteif verklebt.

Innerhalb des wannenförmigen Halteelements 26 befindet sich eine Hinterleuchtungseinheit 46 zum Hinterleuchten des Displays 36, die ein Lichtleiterelement 48 und einen Diffusor 50 zur Homogenisierung des vom Lichtleiterelement 48 in Richtung auf das Display 36 abgestrahlten Lichts aufweist. In das Lichtleiterelement 48 wird in diesem Ausführungsbeispiel über an der Innenseite der Stützteile angeordnete LEDs als Lichtquellen 52 Licht eingespeist. Auch diese Technologie ist grundsätzlich bekannt und soll hier nicht weiter erläutert werden.

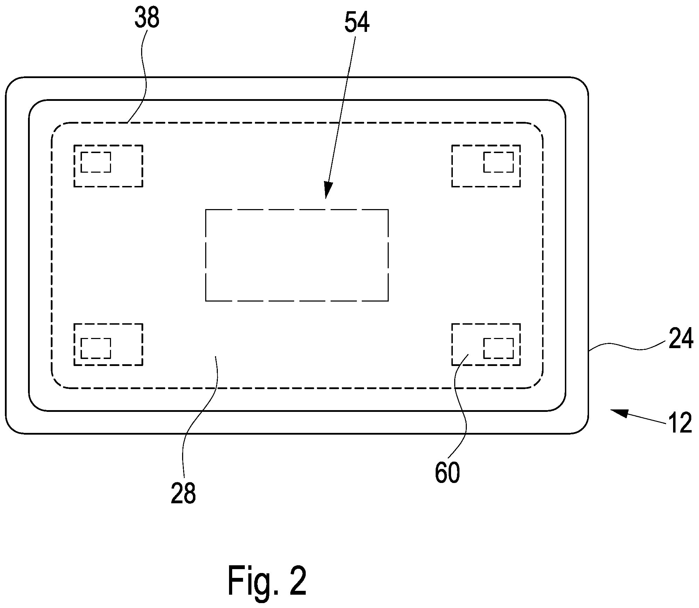

Eine Besonderheit der Bedienvorrichtung 10 gemäß Fig. 1 ist in der starren Verbindung des Halteelements 26 mit der Rückwand 22 des Gehäuses 12 zu sehen. Dies ist in Fig. 1 gezeigt. Hierbei ist ein Mittenbereich 54 der Bodenwand 28 mit der Rückwand 22 des Gehäuses 12 verbunden. Der Umgebungsbereich 56 der Bodenwand 28, der sich um den Mittenbereich 54 allseitig herum erstreckt, ist mit Abstand zur Rückwand 22 des Gehäuses 12 angeordnet (siehe den Spaltraum 58). In diesem Zwischenraum befinden sich vorzugsweise in den Eckenbereichen der Bodenwand 28 Betätigungssensoren 60, wie dies in Fig. 2 angedeutet ist.

Die Betätigungssensoren 60 liefern ihre Messsignale an eine Auswerteeinheit 62, die darüber hinaus auch von der Berührungssensorik (Touch-Panel 42) des Displays 36 Informationen empfängt. In der Auswerteeinheit 62 erfolgt nun die Analyse der Signale der Betätigungssensoren 60, um zu entscheiden, ob bei manueller Betätigung der Bedienoberfläche 20 gegen diese mit einer Mindestandrückkraft gedrückt worden ist, was für eine valide Betätigung der Bedienoberfläche 20 maßgebend ist.

Die Bedienvorrichtung 10 ist darüber hinaus mit einer Haptik-Feedback-Funktionalität ausgestattet. Zu diesem Zweck weist die Bedienvorrichtung 10 einen Aktuator 64 auf, der beispielsweise als elektromagnetisches Stellglied oder aber auch als Piezoaktuator ausgebildet ist. Aufgabe dieses Aktuators 64 ist es, bei Erkennung einer validen Betätigung des Bedienelements 18 dieses lateral impulsartig mechanisch anzuregen. Zu diesem Zweck dient unter anderem das elastische Verbindungselement 44, das einerseits die Kraft- bzw. Momentenübertragung vom Bedienelement 18 über das Halteelement 26 zu den Betätigungssensoren 60 erlaubt und andererseits aber auch eine lateral wirkende Scherung ermöglicht.

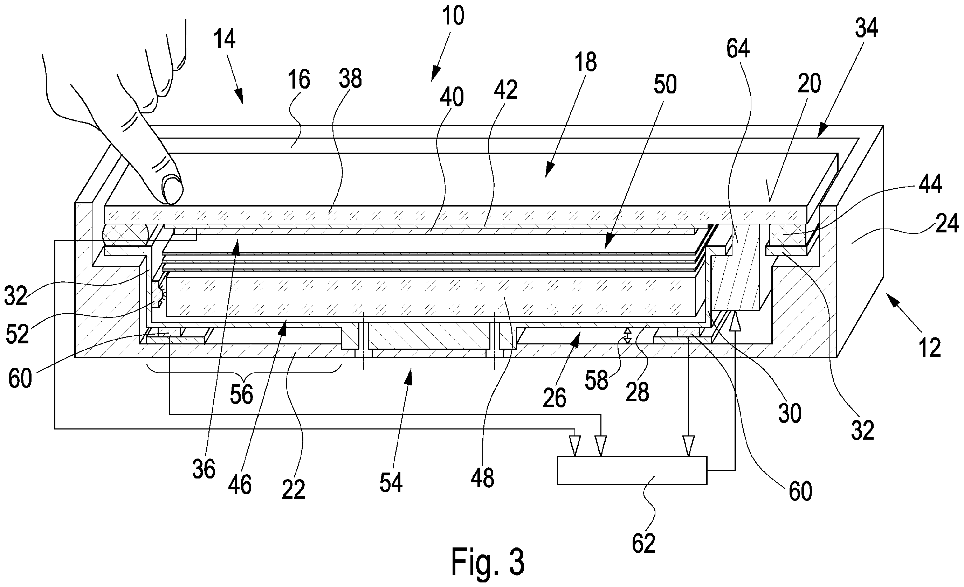

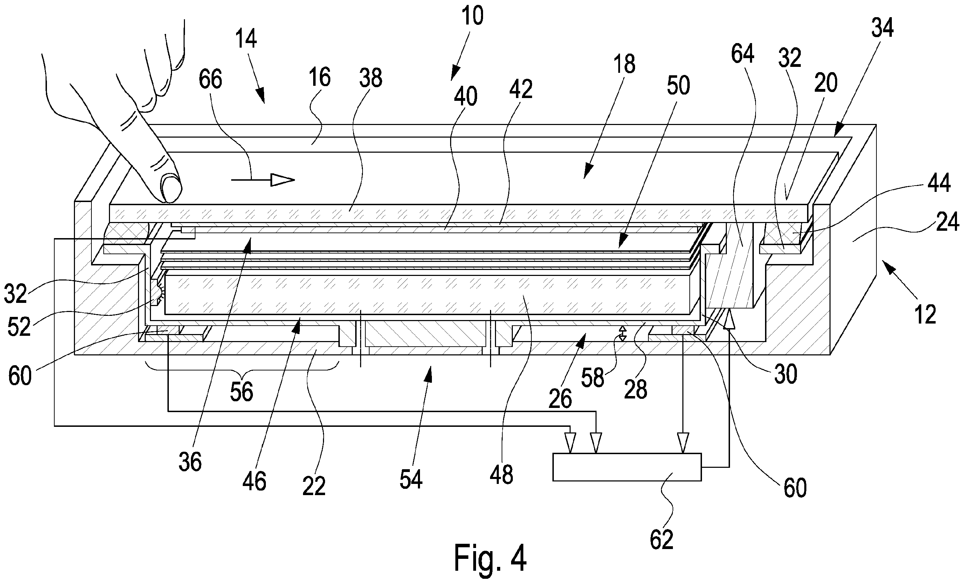

Dies ist in den Fign. 3 und 4 gezeigt. In Fig. 3 ist die Situation im Augenblick der manuellen Berührung der Bedienoberfläche 20 mit einer für eine valide Betätigung erforderlichen Mindestandrückkraft gezeigt. Die Betätigungssensoren 60 sensieren eine Andrückkraft. Wenn diese größer ist als die Mindestandrückkraft, gibt die Auswerteeinheit 62 ein Ansteuersignal an den Aktuator 64 aus, der das Bedienelement 18 impulsartig mechanisch lateral anregt, was in Fig. 4 mit dem Pfeil 66 angedeutet ist.

In Fig. 3 ist gezeigt, dass bei einer dezentralen manuellen Druckausübung auf die Bedienoberfläche 20 die Betätigungssensoren 60, die dem Berührungspunkt der Bedienoberfläche 20 gegenüberliegen (d.h. der bzw. die beiden in Fig. 3 rechts gezeigten Berührungssensoren 60) noch Kontakt zum Halteelement 26 haben. Bei Druck- oder Kraftsensoren als Betätigungssensoren 60 ist dies gegebenenfalls sinnvoll. Bei Einsatz von Wegsensoren als Betätigungssensoren 60 kann hier auch ein Abstand zwischen diesen Sensoren und dem Halteelement 26 (bei Anordnung der Sensoren auf der Rückwand 22 des Gehäuses 12) oder zwischen diesen Sensoren und der Rückwand 22 (bei Anordnung dieser Sensoren an der Unterseite des Halteelements 26) entstehen bzw. im Ruhezustand des Bedienelements 18 vorhanden sein.

Die Betätigungssensoren 60 können neben der Detektion, ob bei Berührung der Bedienoberfläche 20 mit der vorgebbaren Mindestandrückkraft gearbeitet worden ist, auch dazu genutzt werden, um den Ort, an dem manuell auf das Bedienelement 18 eingewirkt worden ist, zu detektieren. Die Kraft, mit der gegen die Bedienoberfläche 20 manuell gedrückt wird, wirkt sich je nach dem Ort, an dem auf die Bedienoberfläche 20 eingewirkt wird, als unterschiedlich große Messsignale der mehreren Betätigungssensoren 60 aus. Durch vorherige entsprechende Kalibrierung kann dann je nach Messsignalmuster auf den Ort der manuellen Betätigung der Bedienoberfläche 20 geschlossen werden.

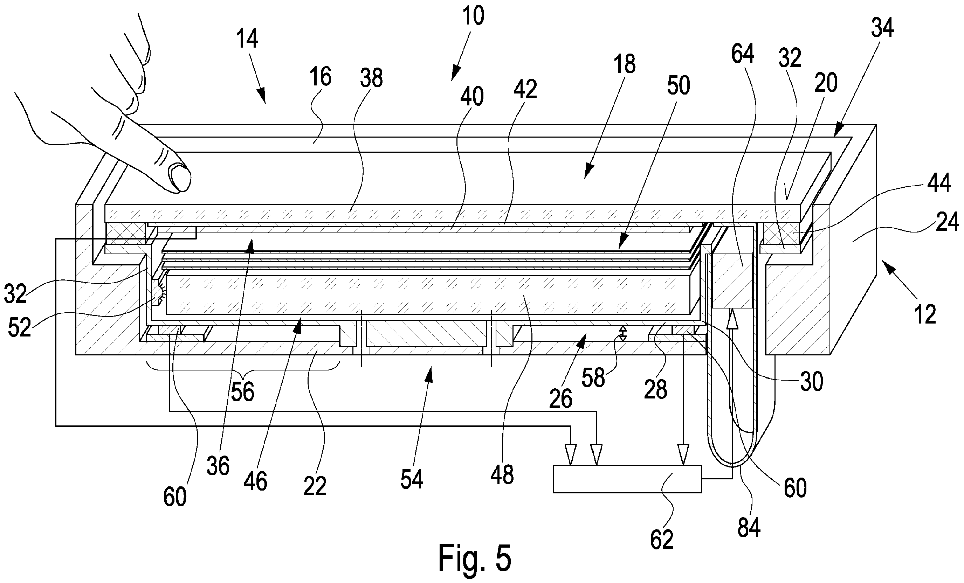

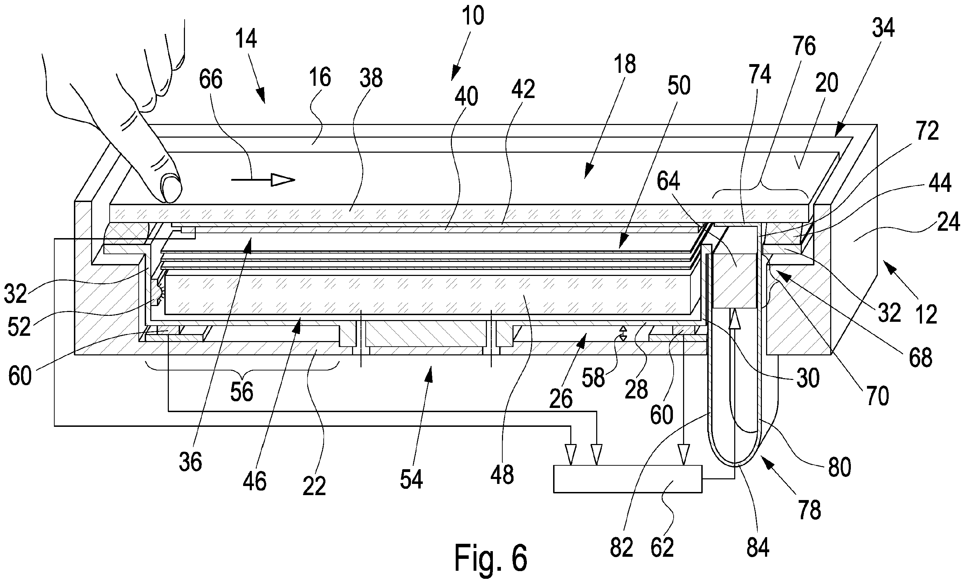

Die Fign. 5 und 6 zeigen ein erstes Ausführungsbeispiel, gemäß dem die Bedieneinheit 10 nach den Fign. 1 bis 4 erfindungsgemäß ergänzt ist, um auf die Abdeckscheibe 38 wirkende Dreh- bzw. Kippmomente zu kompensieren, die entstehen, wenn die Abdeckscheibe 38 impulsartig lateral angeregt wird. Zu diesem Zweck befindet sich zwischen dem Aktuator 64 und der Abdeckscheibe 38 ein Betätigungsarm 68, der einen bei 70 angedeuteten Einwirkungspunkt oder Einwirkungsbereich aufweist, in dem bzw. innerhalb dessen der Aktuator 64 zum seitlichen Verschieben des Betätigungsarms 68 auf diesen einwirkt. Bei dem Aktuator 64 handelt es sich um einen Piezoaktuator oder aber auch um einen elektromechanisch oder elektromagnetisch wirkenden Aktuator.

Zwischen dem Einwirkungspunkt 70 und der Abdeckscheibe 38 weist der Betätigungsarm 68 einen Verschiebeabschnitt 72 auf, der an seinem Ende 74 fest mit der Abdeckscheibe 38 verbunden ist, und zwar an deren Unterseite innerhalb eines Überstandsbereichs 76 der Abdeckscheibe 38.

Bezogen auf den Einwirkungspunkt bzw. Einwirkungsbereich 70 erstreckt sich der Betätigungsarm 68 zu der dem Verschiebeabschnitt 72 abgewandten Seite innerhalb eines Verlängerungsabschnitts 78. Dieser Verlängerungsabschnitt 78 weist einen ersten Teilabschnitt 80 auf, der sich von dem Einwirkungspunkt bzw. Einwirkungsbereich 70 aus erstreckt, und einen zweiten Teilabschnitt 82 auf, der sich an den ersten Teilabschnitt 80 anschließt und im Gehäuse 12, nämlich in diesem Ausführungsbeispiel am Halteelement 26, nämlich z. B. an einem der Stützteile 30 des Halteelements 26, befestigt ist. Auch der Aktuator 64 stützt sich an dem Halteelement 26 bzw. an dem besagten Stützteil 30 des Halteelements direkt oder indirekt ab.

Wesentlich für die erfindungsgemäß vorteilhafte, von Dreh- bzw. Kippmomenten im Wesentlichen freie Lateralbewegung der Abdeckscheibe 38 ist die elastische Ausbildung des Betätigungsarms 68 in seinem, bezogen auf den Einwirkungspunkt 70 der Abdeckscheibe 38 gegenüberliegenden Bereich, also im Bereich des Verlängerungsabschnitts 78. Dies gelingt im Ausführungsbeispiel gemäß den Fign. 5 und 6 dadurch, dass die beiden Teilabschnitte 80, 82 durch einen Bogenabschnitt 84 elastisch miteinander verbunden sind. Das Material, aus dem der Betätigungsarm 68 gefertigt ist, ist vorzugsweise ebenfalls flexibel und rückstellfähig. Beispielsweise kann es sich dabei um Federstahl odgl. handeln.

Die Funktionsweise des Drehmomentenausgleichs ist wie folgt. Durch die Verlängerung des Betätigungsarms 68 (ausgehend von der Abdeckscheibe 38 über den Einwirkungspunkt 70 hinaus in den Verlängerungsabschnitt 78 hinein) bewirkt, dass im Verlängerungsabschnitt 78 ebenfalls ein Drehmoment auf den Betätigungsarm 68 ausgeübt wird, was zur Kompensation einer Dreh- bzw. Kippbewegung der Abdeckscheibe 38 bei Lateralbewegung führt. Statt des Vorhandenseins des bogenförmigen Abschnitts 84 könnte der Verlängerungsabschnitt 78 des Betätigungsarms 68 am Ende des ersten Teilabschnitts 78 am Gehäuse oder außerhalb des Gehäuses 12 der Bedieneinheit 10 befestigt sein.

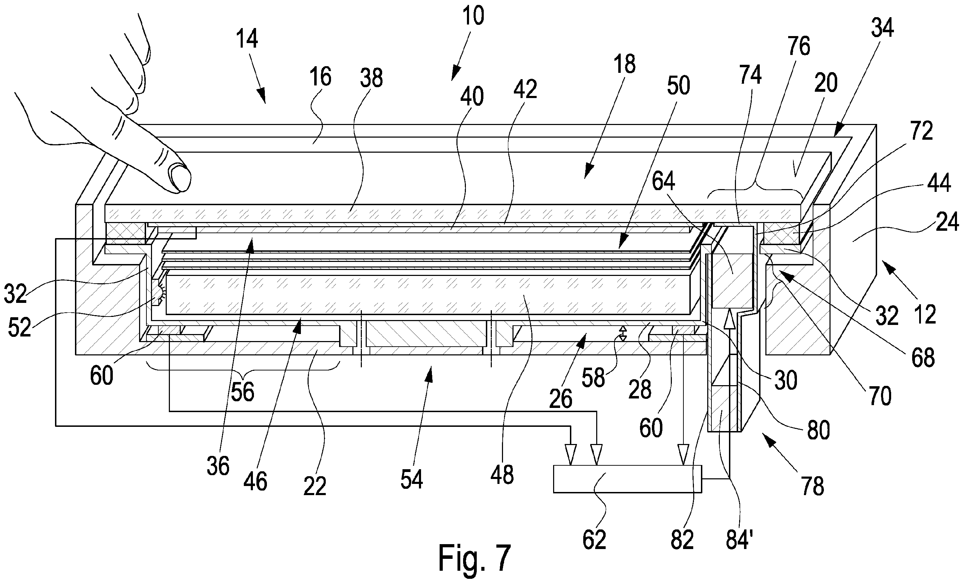

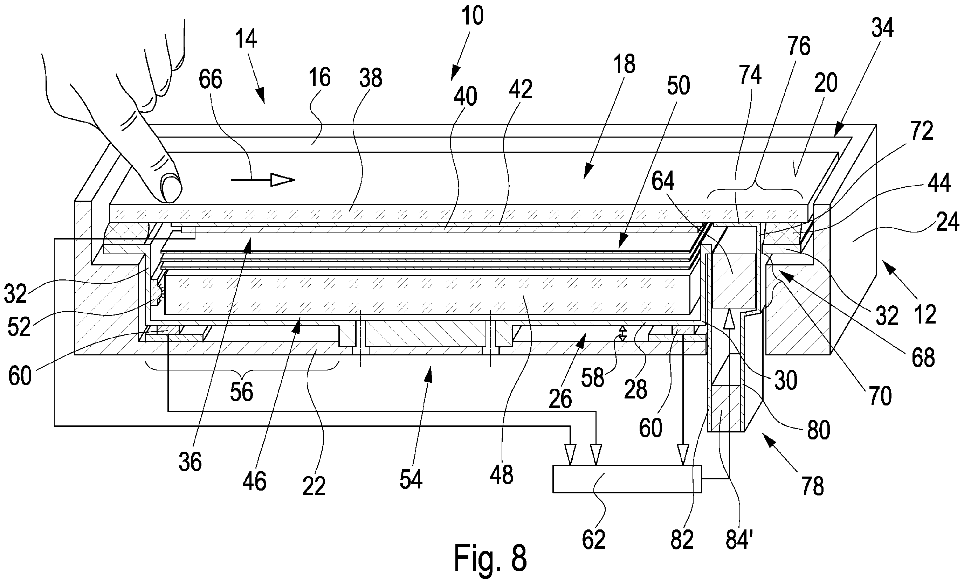

In den Fign. 7 und 8 ist ein zweites Ausführungsbeispiel der erfindungsgemäß ausgeführten Bedieneinheit 10 gezeigt. Der Unterschied zur Ausführungsform gemäß den Fign. 5 und 6 besteht in der Ausgestaltung des Betätigungsarms 68. Soweit die Elemente dieses Betätigungsarms 68 denjenigen des Betätigungsarms 68 des Ausführungsbeispiels nach den Fign. 5 und 6 konstruktiv oder funktional gleichen bzw. entsprechen, sind sie in den Fign. 7 und 8 mit den gleichen Bezugszeichen wie in den Fign. 5 und 6 bezeichnet.

Der Unterschied in der Konstruktion des Betätigungsarms 68 in den Fign. 7 und 8 gegenüber den Fign. 5 und 6 ist darin zu sehen, dass die beiden Teilabschnitte 80 und 82 nicht mehr über einen Bogenabschnitt, sondern durch ein elastisches dehnbares Verbindungselement 84' miteinander verbunden sind. Bei dem elastischen Verbindungselement 84' handelt es sich beispielsweise um ein elastomeres Material, so dass dem Verlängerungsabschnitt 78 wiederum eine Elastizität bzw. eine zusätzliche Elastizität verliehen wird, die für den Drehmomentenausgleich, wie oben beschrieben, sorgt.

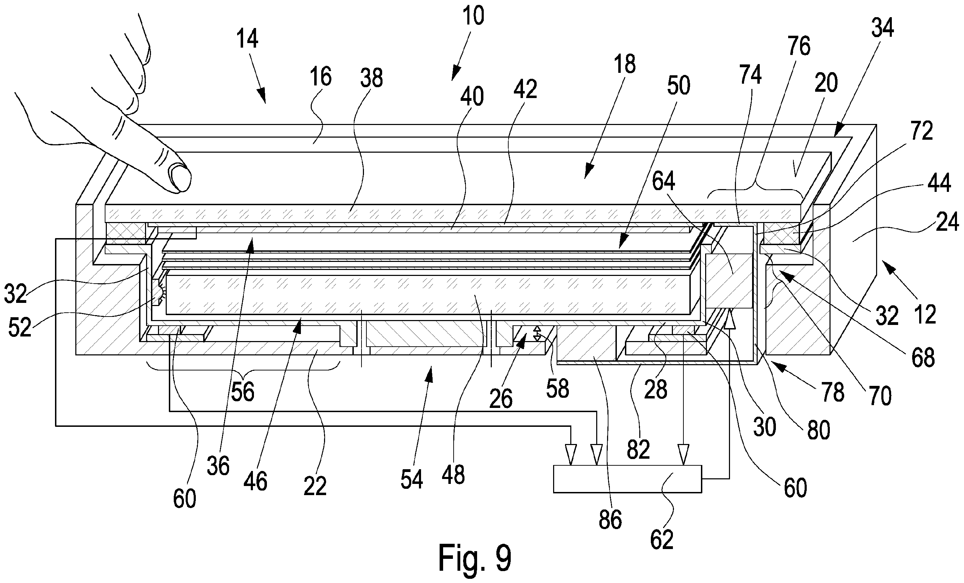

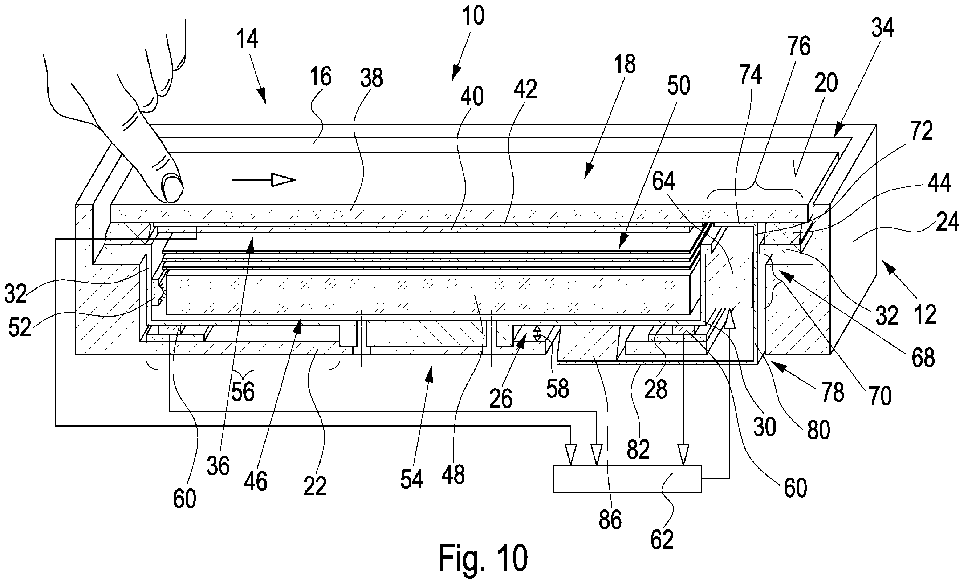

In den Fign. 9 und 10 ist ein drittes Ausführungsbeispiel einer erfindungsgemäßen Bedieneinheit 10 gezeigt. Auch hier gilt, dass sich diese Ausführungsform gegenüber denjenigen der Fign. 5 bis 8 durch die Ausgestaltung des Betätigungsarms 68 unterscheidet. Mit dem Betätigungsarm 68 der Ausführungsbeispiele nach den Fign. 5 bis 8 konstruktiv gleiche bzw. funktional gleiche Elemente sind in den Fign. 9 und 10 mit den gleichen Bezugszeichen wie in den zuvor genannten Figuren bezeichnet.

Im Unterschied zu den Ausführungsformen der Betätigungsarme 68 in den Fign. 5 bis 8 ist der Betätigungsarm 68 in den Fign. 9 und 10 mit einem in diesem Ausführungsbeispiel rechtwinklig ausgeführtem Verlängerungsabschnitt 78 versehen. Der zweite Teilabschnitt 82 ist also rechtwinklig zum ersten Teilabschnitt 80 ausgerichtet und an seinem Ende über ein elastisches Verbindungselement 86 an der Unterseite der Bodenwand 28 des Halteelements 26 befestigt. Durch dieses elastische Verbindungselement 86, das bei seitlicher Verschiebung des Betätigungsarms 68 schert, wird dem Verlängerungsabschnitt 78 wiederum eine Elastizität verliehen, die für den Drehmomentenausgleich an der Abdeckscheibe 38 sorgt.

### BEZUGSZEICHENLISTE

- 10: Bedienvorrichtung
- 12: Gehäuse
- 14: Vorderseite des Gehäuses
- 16: Aufnahmeöffnung in der Vorderseite
- 18: Bedienelement
- 20: Bedienoberfläche des Gehäuses
- 22: Rückwand des Gehäuses
- 24: Seitenwände des Gehäuses
- 26: Halteelement
- 28: Bodenwand des Halteelements
- 30: Stützteile des Halteelements
- 32: Montageflansch der Stützteile
- 34: Begrenzungsrandbereich des Bedienelements
- 36: Display
- 38: Abdeckscheibe des Displays
- 40: Anzeigeeinheit des Displays
- 42: Touch-Panel des Displays
- 44: Verbindungselement
- 46: Hinterleuchtungseinheit des Displays
- 48: Lichtleiterelement der Hinterleuchtungseinheit
- 50: Diffusor der Hinterleuchtungseinheit
- 52: Lichtquellen der Hinterleuchtungseinheit
- 54: Mittenbereich der Bodenwand
- 56: Umgebungsbereich um den Mittenbereich
- 60: Betätigungssensoren
- 62: Auswerteeinheit
- 64: Aktuator
- 66: Pfeil
- 68: Betätigungsarm
- 70: Einwirkungspunkt
- 72: Verschiebeabschnitt des Betätigungsarms
- 74: Ende des Verschiebeabschnitts des Betätigungsarms
- 76: Überstandsbereich der Abdeckscheibe des Dislays
- 78: Verlängerungsabschnitt des Betätigungsarms
- 80: erster Teilabschnitt des Verlängerungsabschnitts des Betätigungsarms
- 82: zweiter Teilabschnitt des Verlängerungsabschnitts des Betätigungsarms
- 84: elastisches Verbindungselement
- 84': elastisches Verbindungselement
- 86: elastisches Verbindungselement

## Patentansprüche

1. Bedieneinheit für ein Fahrzeug, mit
- einem Gehäuse (12) mit einer Vorderseite (14),
- einem Bedienelement (18) an der Vorderseite (14) des Gehäuses (12),
- einer Sensorik (42, 60), eingerichtet zur Ermittlung einer durch Berührung einer Bedienoberfläche mit einer vorgebbaren Mindestandrückkraft erfolgenden manuellen Betätigung des Bedienelements (18),
- einem Aktuator (64) mit einem Antrieb und einem von dem Antrieb angetriebenen Stellelement,
- wobei der Antrieb des Aktuators (64) direkt oder indirekt starr mit dem Gehäuse (12) gekoppelt ist und sich an diesem abstützt,
- einem Betätigungsarm (68), der von dem Bedienelement (18) absteht und auf den das Stellelement des Aktuators (64) an einem Einwirkungspunkt (70) des Betätigungsarms (68) mechanisch einwirkt,
- wobei der Betätigungsarm (68) einen sich zwischen einer Abdeckscheibe (38) und dem Einwirkungspunkt (70) erstreckenden Verschiebeabschnitt (72) zur Lateralverschiebung der Abdeckscheibe (38) aufweist, und
- einer Auswerte- und Ansteuereinheit (62), die eingerichtet ist, von der Sensorik Messsignale zu empfangen und bei Erkennung einer validen Betätigung des Bedienelements (18) an den Antrieb des Aktuators (64) ein Ansteuersignal zur impulsartigen mechanischen Anregung des Betätigungsarms (68) durch das Stellelement des Aktuators (64) auszugeben,
**dadurch gekennzeichnet,**
- **dass** der Bestätigungsarm (68) elastisch ausgebildet ist und von einem Überstandsbereich (76) der Abdeckscheibe (38) absteht,
- **dass** der Betätigungsarm (68) ausgehend von seinem Verschiebeabschnitt (72) über den Einwirkungspunkt (70) hinaus verlängert ist und einen Verlängerungsabschnitt (78) aufweist, innerhalb dessen der Betätigungsarm (68) elastisch und mechanisch fixiert ist,
- **dass** das Bedienelement (18) ein Display (36) mit einer Anzeigefläche (40) und der Abdeckscheibe (38) aufweist, die die Bedienoberfläche des Bedienelements (18) definiert und zumindest den seitlich über das Display (36) überstehenden Überstandsbereich (76) aufweist und die an und/oder in dem Gehäuse (12) elastisch lateral verschiebbar gelagert ist, und
- **dass** der Aktuator (64) unterhalb der Abdeckscheibe (38) des Display (36) angeordnet ist.

2. Bedieneinheit nach Anspruch 1, **dadurch gekennzeichnet, dass** der Betätigungsarm (68) als ein Materialstreifen ausgebildet ist.

3. Bedieneinheit nach einem der Ansprüche 1 oder 2, **dadurch gekennzeichnet, dass** der Betätigungsarm (68) Metall, insbesondere Eisen oder Stahl, insbesondere Federstahl, und/oder Kunststoff aufweist.

4. Bedieneinheit nach einem der Ansprüche 1 bis 3, **dadurch gekennzeichnet, dass** der Betätigungsarm (68) innerhalb seines Verlängerungsabschnitts (78) einen Bogenabschnitt (84) von im Wesentlichen 180 Grad aufweist, wobei das zurückgeführte Ende des Verlängerungsabschnitts (78) mechanisch an und/oder in dem Gehäuse (12) fixiert ist.

5. Bedieneinheit nach einem der Ansprüche 1 bis 3, **dadurch gekennzeichnet, dass** der Verlängerungsabschnitt (78) zwei Teilabschnitte (80, 82) aufweist, die elastisch miteinander verbunden sind, wobei sich der erste Teilabschnitt (80) ausgehend von dem Einwirkungspunkt (70) des Betätigungsarms (68) aus erstreckt und der zweite Teilabschnitt (82) an dem dem Einwirkungspunkt (70) des Betätigungsarms (68) gegenüberliegenden Ende des ersten Teilabschnitts (80) mit diesem verbunden ist.

6. Bedieneinheit nach Anspruch 5, **dadurch gekennzeichnet, dass** zwischen den beiden Teilabschnitten (80, 82) des Verlängerungsabschnitts (78) ein einteilig mit diesem verbundener Bogenabschnitt (84) angeordnet ist, mittels dessen die beiden Teilabschnitte (80, 82) elastisch verbunden sind.

7. Bedieneinheit nach Anspruch 5, **dadurch gekennzeichnet, dass** die beiden Teilabschnitte (80, 82) mittels eines elastischen Materials (84) miteinander verbunden sind, das zwischen im Wesentlichen parallel zueinander verlaufenden Endabschnitten der beiden Teilabschnitte (80, 82) von beiden Endbereichen beidseitig umschlossen angeordnet ist.

8. Bedieneinheit nach Anspruch 7, **dadurch gekennzeichnet, dass** das elastische Material (84) ein Elastomer wie z.B. Gummi oder Silikon aufweist.

9. Bedieneinheit nach einem der Ansprüche 1 bis 8, **dadurch gekennzeichnet, dass** der Aktuator (64) elektromechanisch und/oder elektromagnetisch arbeitet.

10. Bedieneinheit nach einem der Ansprüche 1 bis 9, **dadurch gekennzeichnet, dass** der Aktuator (64) als ein Piezoaktuator mit oder ohne Verstärkungsgetriebe zur Vergrößerung des Hubes des Piezoaktuators ausgebildet ist, wobei der Piezoaktuator sowohl den Antrieb als auch das Stellelement des Aktuators (64) bildet oder, wenn ein Verstärkungsgetriebe vorgesehen ist, der Piezoaktuator den Antrieb des Aktuators (64) und das Verstärkungsgetriebe das Stellelement des Aktuators (64) bildet.

## Claims

1. Operating unit for a vehicle, comprising
- a housing (12) having a front side (14),
- an operating element (18) on the front side (14) of the housing (12),
- a sensory system (42, 60) configured for detection of a manual actuation of the operating element (18) effected by a touch onto the operating surface with a presettable minimum pressing force,
- an actuator (64) comprising a drive unit and an actuating element driven by the drive unit,
- wherein the drive unit of the actuator (64) is rigidly coupled to the housing (12) in a direct or indirect manner and is supported on it,
- an actuation arm (68) which projects from the operating element (18) and which is mechanically acted on by the actuating element of the actuator (64) at a force application point (70) of the actuation arm (68),
- wherein the actuation arm (68) comprises a displacement portion (72) extending between a cover plate (38) and the force application point (70), for lateral displacement of the cover plate (38), and
- an evaluation and control unit (62) which is configured to receive measuring signals from the sensory system and, upon detection of a valid actuation of the operating element (18), to output to the drive unit of the actuator (64) a control signal for pulsed mechanical excitation of the actuation arm (68) by the actuating element of the actuator (64),
**characterized in**
- **that** the actuation arm (68) is elastic and protrudes from a projecting portion (76) of the cover plate (38),
- **that** the actuation arm (68) is extended, starting from its displacement portion (72), beyond the force application point (70) and comprises an extension portion (78) within which the actuation arm (68) is elastically and mechanically fixed,
- **that** the operating element (18) comprises a display (36) having a display surface (40) and the cover plate (38), the cover plate defining an operating surface of the operating element (18) and comprising at least the projecting portion (76) laterally projecting beyond the display (18), and being supported on and/or in the housing (12) in a manner allowing for elastic lateral displacement, and
- **that** the actuator (64) is arranged below the cover plate (38) of the display (36).

2. Operating unit according to claim 1, **characterized in that** the actuation arm (68) is formed as a material strip.

3. Operating unit according to claim 1 or 2, **characterized in that** the actuation arm (68) comprises metal, particularly iron or steel, particularly spring steel or plastics.

4. Operating unit according to any one of claims 1 to 3, **characterized in that** the actuation arm (68) within its extension portion (78) comprises a curved portion (84) of substantially 180 degrees, wherein the bent-back end of the extension portion (78) is mechanically fixed on and/or in the housing (12).

5. Operating unit according to any one of claims 1 to 3, **characterized in that** the extension portion (78) comprises two partial portions (80, 82) which are elastically connected to each other, wherein the first partial portion (80) extends from the force application point (70) of the actuation arm (68) and wherein the second partial portion (82) is connected to the first partial portion (80) at the end of the first partial portion opposite to the force application point (70) of the actuation arm (68).

6. Operating unit according to claim 5, **characterized in that**, between the two partial portions (80, 82) of the extension portion (78), a curved portion (84) is arranged which is integrally connected to the extension portion and by which the two partial portions (80, 82) are elastically connected to each other.

7. Operating unit according to claim 5, **characterized in that** the two partial portions (80, 82) are connected to each other by means of an elastic material (84) which, between end portions (80, 82) of the two partial portions extending substantially parallel to each other, is enclosed on both sides by the two end portions.

8. Operating unit according to claim 7, **characterized in that** the elastic material (84) comprises an elastomer such as, e.g., rubber or silicone.

9. Operating unit according to any one of claims 1 to 8, **characterized in that** the actuator (64) is operating electromechanically and/or electromagnetically.

10. Operating unit according to any one of claims 1 to 9, **characterized in that** the actuator (64) is a piezo actuator with or without amplifying gear for enlarging the stroke of the piezo actuator, wherein the piezo actuator forms both the drive unit and the actuating element of the actuator (64) or, if an amplifying drive is provided, the piezo actuator forms the drive unit of the actuator (64) and the amplifying drive forms the actuating element of the actuator (64).

## Revendications

1. Unité de commande pour un véhicule, dotée
- d'un boîtier (12) doté d'une face avant (14),
- d'un élément de commande (18) sur la face avant (14) du boîtier (12),
- de capteurs (42, 60) configurés pour déterminer un actionnement manuel de l'élément de commande (18) obtenu en touchant une surface de commande avec une force de pression minimale pouvant être prédéfinie,
- d'un actionneur (64) doté d'un entraînement et d'un élément d'ajustement entraîné par l'entraînement,
- dans laquelle l'entraînement de l'actionneur (64) est couplé, directement ou indirectement, de manière rigide au boîtier (12) et s'appuie sur celui-ci,
- d'un bras d'actionnement (68), lequel dépasse de l'élément de commande (18) et sur lequel l'élément d'ajustement de l'actionneur (64) agit mécaniquement à un point d'application (70) du bras d'actionnement (68),
- dans laquelle le bras d'actionnement (68) comporte une section de coulissement (72) s'étendant entre une plaque de protection (38) et le point d'application (70), destinée au coulissement latéral de la plaque de protection (38), et
- d'une unité de contrôle et de commande (62), laquelle est configurée pour recevoir des signaux de mesure des capteurs et pour émettre vers l'entraînement de l'actionneur (64) un signal de commande pour l'excitation mécanique sous forme d'impulsions du bras d'actionnement (68) par l'élément d'ajustement de l'actionneur (64) en cas de reconnaissance d'un actionnement valide de l'élément de commande (18),
**caractérisée**
- **en ce que** le bras d'actionnement (68) est réalisé de manière élastique et dépasse d'une zone en saillie (76) de la plaque de protection (38),
- **en ce que** le bras d'actionnement (68) se prolonge à partir de sa section de coulissement (72) au-delà du point d'application (70) et comporte une section de prolongement (78), à l'intérieur de laquelle le bras d'actionnement (68) est fixé de manière élastique et mécanique,
- **en ce que** l'élément de commande (18) comporte un écran (36) doté d'une surface d'affichage (40) et de la plaque de protection (38), laquelle définit la surface de commande de l'élément de commande (18) et comporte au moins la zone en saillie (76) saillant latéralement de l'écran (36) et laquelle est disposée sur et/ou dans le boîtier (12) de manière à pouvoir coulisser latéralement de manière élastique, et
- **en ce que** l'actionneur (64) est disposé en-dessous de la plaque de protection (38) de l'écran (36).

2. Unité de commande selon la revendication 1, **caractérisée en ce que** le bras d'actionnement (68) est réalisé comme une bande de matière.

3. Unité de commande selon la revendication 1 ou 2, **caractérisée en ce que** le bras d'actionnement (68) comporte du métal, en particulier du fer ou de l'acier, en particulier de l'acier à ressort, et/ou du plastique.

4. Unité de commande selon l'une des revendications 1 à 3, **caractérisée en ce que** le bras d'actionnement (68) comporte à l'intérieur de sa section de prolongement (78) une section courbée (84) faisant sensiblement un angle de 180°, dans laquelle l'extrémité ramenée vers l'arrière de la section de prolongement (78) est fixée mécaniquement sur et/ou dans le boîtier (12).

5. Unité de commande selon l'une des revendications 1 à 3, **caractérisée en ce que** la section de prolongement (78) comporte deux sections partielles (80, 82) reliées l'une à l'autre de manière élastique, dans laquelle la première section partielle (80) s'étend à partir du point d'application (70) du bras d'actionnement (68) et la deuxième section partielle (82) est reliée à la première section partielle (80) à son extrémité opposée au point d'application (70) du bras d'actionnement (68).

6. Unité de commande selon la revendication 5, **caractérisée en ce qu'**entre les deux sections partielles (80, 82) de la section de prolongement (78) est disposé une section courbée (84) reliée d'une pièce à celles-ci, au moyen de laquelle les deux sections partielles (80, 82) sont reliées de manière élastique.

7. Unité de commande selon la revendication 5, **caractérisée en ce que** les deux sections partielles (80, 82) sont reliées l'une à l'autre au moyen d'un matériau élastique (84), lequel est disposé pour être entouré des deux côtés par les deux zones d'extrémité entre les deux sections d'extrémités des deux sections partielles (80, 82) sensiblement parallèles l'une à l'autre.

8. Unité de commande selon la revendication 7, **caractérisée en ce que** le matériau élastique (84) est un élastomère comme par exemple du caoutchouc ou du silicone.

9. Unité de commande selon l'une des revendications 1 à 8, **caractérisée en ce que** l'actionneur (64) fonctionne de manière électromécanique et/ou électromagnétique.

10. Unité de commande selon l'une des revendications 1 à 9, **caractérisée en ce que** l'actionneur (64) est réalisé comme actionneur piézoélectrique avec ou sans transmission amplificatrice destinée à accroître la course de l'actionneur piézoélectrique, dans laquelle l'actionneur piézoélectrique forme aussi bien l'entraînement que l'élément d'ajustement de l'actionneur (64) ou, lorsqu'une transmission amplificatrice est prévue, l'actionneur piézoélectrique forme l'entraînement de l'actionneur (64) et la transmission amplificatrice forme l'élément d'ajustement de l'actionneur (64).
